# DEMANDE DE BREVET EUROPEEN

(11) **EP 4 369 415 A1**
(43) Date de publication de la demande: **15.05.2024**
(21) Numéro de dépôt: 23209323.7
(22) Date de dépôt: 13.11.2023
(51) Int. Cl.: H01L 29/66, H01L 29/786, H01L 29/78, H01L 27/12, H01L 29/10, H01L 21/265

(54) **PROCÉDÉ DE RÉALISATION D'UN DISPOSITIF MICROÉLECTRONIQUE AYANT UNE GRILLE EN T**

(30) Priorité: 14.11.2022 FR 2211820
(71) Demandeur: Commissariat à l'énergie atomique et aux énergies alternatives, 75015 Paris (FR)
(72) Inventeur: DURIEZ, Blandine, 38054 Grenoble Cedex 09 (FR); ANDRIEU, François, 38054 Grenoble Cedex 09 (FR); CHALUPA, Zdenek, 38054 Grenoble Cedex 09 (FR); FACHE, Thibaud, 38054 Grenoble Cedex 09 (FR); HARTMANN, Jean-Michel, 38054 Grenoble Cedex 09 (FR); REBOH, Shay, 38054 Grenoble Cedex 09 (FR)
(74) Mandataire: Hautier IP

(57) **Abrégé**

L'invention porte sur un procédé de réalisation d'un dispositif microélectronique comprenant les étapes suivantes :
- une formation d'un motif de grille sur le substrat, surmontant un canal de conduction,
- une formation d'espaceurs définissant des régions source et drain,
- une modification des régions source et drain pour générer une contrainte en tension dans le canal de conduction ;

avantageusement, le procédé comprend :
- avant formation du motif de grille, une formation d'une couche précontrainte en compression, sur le substrat,
- une formation d'une couche active sur la couche précontrainte, ladite couche active étant destinée à accueillir le canal de conduction ;

avantageusement, la modification des régions source et drain est configurée pour relâcher élastiquement la contrainte en compression de la couche précontrainte, de sorte à appliquer l'état de contrainte en tension dans le canal.

## Description

### DOMAINE TECHNIQUE

La présente invention concerne en général les dispositifs microélectroniques. Elle trouve pour application particulièrement avantageuse la réalisation de transistors NMOS, c'est-à-dire de transistors Métal-Oxyde-Semiconducteur de type N, pour des composants radiofréquence (RF).

### ETAT DE LA TECHNIQUE

Pour améliorer les performances électriques des composants RF, un axe de développement majeur concerne l'augmentation de la mobilité des électrons dans le canal de conduction des transistors NMOS.

Les fréquences de transition ou de coupure du transistor sont en effet directement proportionnelles à la mobilité des électrons dans le canal de conduction du transistor.

Une solution pour augmenter la mobilité des électrons dans un canal à base de silicium consiste à appliquer un état de contrainte en tension dans le canal, de préférence selon l'axe le long duquel circulent les électrons.

L'utilisation d'un substrat précontraint, typiquement un substrat de type silicium sur isolant comprenant une couche supérieure en silicium contraint en tension sSOI (acronyme de « strained Silicon On Insulator »), permet d'améliorer significativement les performances des transistors NMOS par rapport à l'utilisation d'un substrat de type silicium sur isolant SOI standard. Une telle solution, qui n'est pas localisée aux seules zones de transistors NMOS, ne permet cependant pas de former à la fois des transistors NMOS et PMOS aux performances améliorées. A l'inverse, un canal en tension pour un transistor PMOS dégrade la mobilité des trous, et limite les performances d'un tel transistor.

Une autre solution divulguée par le document « Novel Stress-Memorization-Technology (SMT) for High Electron Mobility Enhancement of Gate Last High-k/Metal Gate Devices, Kwan-Yong Lim et al., IEDM10 229-232 » permet de localiser la déformation uniquement au niveau du canal de conduction des transistors NMOS. Dans ce procédé connu, après formation du motif de grille du transistor et des espaceurs, une modification des régions source et drain est effectuée de part et d'autre du canal de conduction. En particulier, une amorphisation par implantation des régions source et drain est effectuée. Une couche contraignante usuellement appelée « stress liner » est ensuite déposée en surface des régions source et drain amorphisées. Une recristallisation des régions source et drain est ensuite effectuée, en présence du stress liner. La recristallisation est ainsi effectuée sous contrainte, typiquement en compression, dans les régions source et drain de part et d'autre du canal de conduction. Cela a pour effet d'induire une contrainte en tension dans le canal. Les défauts structuraux émergeant lors de la recristallisation, notamment les dislocations et les fautes d'empilement, sont avantageusement confinés au niveau des régions source et drain. Avec cette solution, l'application de l'état de contrainte n'est cependant pas optimisée. Un objet de la présente invention est de pallier les limitations des solutions connues.

Un autre objet de la présente invention est de proposer un procédé de réalisation d'un dispositif microélectronique permettant d'appliquer un état de contrainte en tension dans le canal de façon efficace.

Un autre objet de la présente invention est de proposer un dispositif microélectronique présentant un tel état de contrainte dans le canal.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un procédé de réalisation d'un dispositif microélectronique comprenant au moins les étapes suivantes :
- Une fourniture d'un substrat,
- Une formation d'un motif de grille sur le substrat, ledit motif de grille étant destiné à surmonter un canal de conduction,
- Une formation d'espaceurs autour du motif de grille,
- Une formation de régions source et drain de part et d'autre des espaceurs,
- Une modification des régions source et drain destinée à générer un état de contrainte en tension dans le canal de conduction sous le motif de grille.

Avantageusement, le procédé comprend en outre :
- Avant la formation du motif de grille, sur le substrat, une formation d'une couche précontrainte présentant une contrainte en compression,
- Une formation d'une couche active sur la couche précontrainte, ladite couche active étant destinée à accueillir le canal de conduction.

Avantageusement, la modification des régions source et drain est configurée pour relâcher élastiquement la contrainte en compression d'une partie de la couche précontrainte située sous le canal de conduction, de sorte à appliquer l'état de contrainte en tension dans le canal de conduction.

Ainsi, c'est la relaxation élastique de la couche précontrainte qui entraîne une mise en tension du canal de conduction. Contrairement à la solution connue décrite ci-dessus, l'élément permettant d'appliquer l'état de contrainte dans le canal de conduction est situé au plus près dudit canal, typiquement juste en-dessous. L'utilisation connue du stress liner ne permet pas d'appliquer directement l'état de contrainte dans le canal. Le stress liner applique une contrainte aux régions source et drain, qui elles-mêmes appliquent une contrainte au canal de conduction après recristallisation. Il est donc apparu, dans le cadre du développement de la présente invention, qu'une déperdition de la contrainte appliquée survenait lors de la mise en oeuvre de la solution connue avec stress liner. Cette déperdition est notamment due au fait que le mécanisme d'application de la contrainte dans le canal est indirect.

Au contraire, selon le principe de l'invention, c'est la couche précontrainte sous-jacente au canal qui permet d'appliquer directement la contrainte dans le canal, par relaxation. L'application de la contrainte au canal est ainsi plus efficace.

La relaxation de la couche précontrainte sous le canal est opérée par modification des régions source et drain. Cette modification s'étend de préférence jusque dans la couche précontrainte, de part et d'autre du canal, et de préférence sur toute l'épaisseur de la couche précontrainte. Cela permet d'augmenter la relaxation élastique de la partie de couche précontrainte située sous le canal. L'état de contrainte induit dans le canal est alors augmenté.

Avantageusement, la couche active n'est pas modifiée avant formation des espaceurs, de sorte que la couche active présente des zones dites tampon, non modifiées, situées à l'aplomb des espaceurs, de part et d'autre du canal de conduction. Ces zones tampon permettent notamment d'éviter que des dislocations générées dans les régions source et drain atteignent le canal de conduction.

Selon un exemple, la modification des régions source et drain peut être effectuée par amorphisation. Selon un autre exemple, la modification des régions source et drain peut être effectuée par gravure.

L'invention concerne également un dispositif microélectronique comprenant un substrat, un motif de grille surmontant ledit substrat, des espaceurs bordant ledit motif de grille, et des régions dites source et drain de part et d'autre du motif de grille, ledit dispositif comprenant en outre un canal de conduction sous le motif de grille et présentant un état de contrainte en tension. Le dispositif comprend en outre une couche partiellement relaxée sur le substrat, et une couche active accueillant le canal de conduction, sur ladite couche partiellement relaxée, ladite couche active présentant l'état de contrainte en tension au niveau du canal de conduction.

Avantageusement, la couche active présente des dislocations de part et d'autre du canal de conduction, au niveau des régions source et drain, sans dislocations dans ledit canal de conduction.

Un tel dispositif peut être obtenu en mettant en oeuvre le procédé de réalisation selon l'invention.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
Les figures 1A à 1G illustrent schématiquement des étapes d'un procédé de réalisation d'un dispositif microélectronique selon un mode de réalisation de la présente invention.
Les figures 2A à 2E illustrent schématiquement des étapes d'un procédé de réalisation d'un dispositif microélectronique selon un autre mode de réalisation de la présente invention.
Les figures 3A à 3D illustrent schématiquement des étapes d'un procédé de réalisation d'un dispositif microélectronique selon un autre mode de réalisation de la présente invention.
Les figures 4A à 4C illustrent schématiquement des étapes d'un procédé de réalisation d'un dispositif microélectronique selon un autre mode de réalisation de la présente invention.
La figure 5A est une simulation par éléments finis illustrant l'état de contrainte dans un dispositif microélectronique selon un mode de réalisation de la présente invention.
La figure 5B illustre des courbes de contraintes issues de simulations par éléments finis dans un dispositif microélectronique selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches et portions, et les dimensions des motifs ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le procédé comprend en outre :
- une formation de tranchées d'isolation dans le substrat,
- une gravure partielle du substrat entre les tranchées d'isolation de sorte à former une cavité.

Pour un substrat de type silicium sur isolant SOI, la gravure partielle est de préférence configurée de sorte à conserver une partie de la couche de silicium supérieure appelée « top Si ». Cette partie peut typiquement former un germe pour une épitaxie ultérieure, notamment pour l'épitaxie de la couche précontrainte dans la cavité.

Selon un exemple, la couche précontrainte et la couche active sont formées par épitaxie dans ladite cavité. Cela permet d'améliorer l'intégration du dispositif, par exemple au sein d'une architecture monolithique de composant microélectronique. La couche active présente de préférence une surface supérieure en affleurement du sommet des tranchées d'isolation. Selon un exemple, la modification des régions source et drain comprend les sous-étapes suivantes :
- Une amorphisation par implantation d'au moins un type d'atome, dans une partie de chacune des régions source et drain s'étendant jusque dans la couche précontrainte,
- Une recristallisation des parties amorphisées.

Selon un exemple, l'amorphisation par implantation est effectuée à base d'atomes de germanium ou d'arsenic. Les atomes de germanium permettent d'amorphiser sans doper les régions source et drain. Cela permet d'envisager indépendamment les étapes d'amorphisation et de dopage des régions source et drain. Les atomes d'arsenic permettent d'amorphiser les régions source et drain tout en les dopant. Cela permet de gagner une étape de procédé, en réalisant en même temps l'amorphisation et le dopage des régions source et drain.

Selon un exemple, la recristallisation est effectuée par recuit à une température supérieure ou égale à 600°C, typiquement pendant plusieurs minutes ou dizaines de minutes. Selon un autre exemple, la recristallisation est effectuée par un recuit de type « activation » ou recuit thermique rapide RTA (acronyme de Rapid Thermal Annealing), à une température supérieure ou égale à 1000°C pendant quelques secondes ou quelques dizaines de secondes. Cela permet de gagner une étape de procédé, en réalisant en même temps la recristallisation des régions source et drain et l'activation des dopants.

Selon un exemple, la modification des régions source et drain comprend les sous-étapes suivantes :
- Une gravure d'une partie de chacune des régions source et drain s'étendant jusque dans la couche précontrainte,
- Une épitaxie d'un matériau semiconducteur au niveau des parties gravées.

La gravure, en formant des surfaces libres au niveau de la couche précontrainte, permet d'augmenter la relaxation de la couche précontrainte et, par suite, l'état de tension dans la partie de la couche active formant le canal de conduction.

Selon un exemple, le matériau semiconducteur choisi pour l'épitaxie est du silicium dopé phosphore. La contrainte intrinsèque du silicium dopé au phosphore permet d'augmenter la relaxation de la couche précontrainte et/ou d'augmenter l'état de tension dans la partie de la couche active formant le canal de conduction.

Selon un exemple, la modification des régions source et drain s'étend sur toute une épaisseur de la couche précontrainte. Cela permet d'augmenter l'effet de relaxation de la couche précontrainte et, par suite, l'état de tension dans la partie de la couche active formant le canal de conduction.

Selon un exemple, la formation d'espaceurs est configurée de sorte à ce que les espaceurs présentent une largeur e15 supérieure ou égale à une épaisseur e13 de la couche active. Cela permet d'éviter que les défauts structuraux apparaissant dans les régions source et drain après modification desdites régions source et drain, notamment les fautes d'empilement ou les dislocations obliques, atteignent le canal de conduction. Cela permet typiquement de positionner les défauts structuraux sous les espaceurs, mais pas au niveau du canal. Les zones de la couche active situées à l'aplomb des espaceurs forment des zones tampon de part et d'autre du canal de conduction. Ces zones tampon ne sont typiquement pas modifiées par implantation ou amorphisation. Elles préservent le canal de conduction d'une diffusion de dopants depuis les régions source et drain. Elles protègent le canal de conduction vis-à-vis de la modification des régions source et drain.

Selon un exemple, la formation de la couche précontrainte est configurée de sorte à ce que ladite couche précontrainte présente une épaisseur e12 comprise entre 15 nm et 50 nm. Cette plage de valeurs peut typiquement être élargie de 20%.

Selon un exemple, la formation de la couche active est configurée de sorte à ce que ladite couche active présente une épaisseur e13 comprise entre 5 nm et 15 nm. Cette plage de valeurs peut typiquement être élargie de 20%. Selon un exemple, les épaisseurs e12, e13 sont choisies de sorte que e12 ≥ 3.e13. Cela permet d'augmenter la contrainte en tension dans le canal de conduction.

Selon un exemple, la couche active est à base de silicium et la couche partiellement relaxée est à base de silicium-germanium présentant une concentration en germanium comprise entre 20% et 50%.

Selon un exemple, la couche partiellement relaxée est issue d'une couche précontrainte. La couche partiellement relaxée présente un niveau de contrainte inférieur à celui de la couche précontrainte initiale. La couche partiellement relaxée peut être obtenue en mettant en oeuvre le procédé selon l'invention.

Selon un exemple, la couche active présente des dislocations de part et d'autre du canal de conduction, au niveau des régions source et drain, sans dislocations dans ledit canal.

Selon un exemple, les espaceurs présentent une largeur supérieure ou égale à une épaisseur de la couche active, de préférence supérieure ou égale à 30 nm.

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention. Les caractéristiques d'un aspect de l'invention, par exemple le dispositif ou le procédé, peuvent être adaptées *mutatis mutandis* à l'autre aspect de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants. Ainsi, une couche à base de silicium s'entend par exemple d'une couche Si, Si dopé n, Si dopé p.

En général, mais non limitativement, un espaceur forme une bague autour de la grille, avec un contour fermé ; la description d'un espaceur s'entend de préférence de cet espaceur unique autour de la grille ; cependant, les dessins d'illustration en coupe, généralement selon un plan transverse à la direction longitudinale des grilles, montrent deux parties d'espaceur de part et d'autre des flancs de la grille. Par extension, ces deux parties d'espaceur sont souvent désignées « les espaceurs ». Cette dernière terminologie peut éventuellement être adoptée dans cette demande. Par ailleurs, l'invention s'étend aux modes de réalisation dans lesquels au moins deux espaceurs discontinus recouvrent un motif de grille.

La présente invention permet notamment la fabrication d'au moins un transistor ou d'une pluralité de transistors sur un substrat. Ce substrat peut être massif ou « bulk » selon la terminologie anglo-saxonne, ou encore de type semi-conducteur sur isolant, par exemple un substrat silicium sur isolant SOI (acronyme de l'anglais « silicon on insulator).

L'invention peut également être mise en oeuvre plus largement pour différents dispositifs ou composants microélectroniques.

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 7. Les espaceurs sont typiquement formés en un matériau diélectrique.

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent » se réfèrent à des positions prises selon la direction z.

Les termes « vertical », « verticalement » se réfèrent à une direction selon z. Les termes « horizontal », « horizontalement » se réfèrent à une direction dans le plan xy. Le terme « latéral » se réfère à un plan xz ou yz. Ainsi, les flancs latéraux de la grille s'étendent parallèlement à un plan yz. Sauf mention explicite, l'épaisseur, la hauteur et la profondeur sont mesurées selon z.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

Un état de contrainte mécanique est généralement décrit par un tenseur. Dans le cadre de la présente invention, seules les composantes diagonales du tenseur, et en particulier les composantes dans le plan xy, sont considérées.

Pour déterminer l'architecture du dispositif et la disposition des différentes couches, on peut procéder à des analyses de microscopie électronique, en particulier de Microscopie Electronique à Balayage (MEB) ou de Microscopie Electronique en Transmission (MET ou TEM).

Les compositions chimiques des différentes couches ou régions peuvent être déterminées à l'aide de la méthode bien connue EDX ou X-EDS, acronyme de « energy dispersive x-ray spectroscopy » qui signifie « analyse dispersive en énergie de photons X ».

Cette méthode est bien adaptée pour analyser la composition de couches de faibles épaisseurs telles que la couche active et la couche précontrainte sous-jacente. Elle peut être mise en oeuvre sur des coupes métallurgiques au sein d'un MEB ou d'un MET.

La diffraction d'électrons par précession (PED) peut être mise en oeuvre au sein d'un TEM pour déterminer l'état de contrainte de couches de faibles épaisseurs telles que la couche active et la couche précontrainte sous-jacente. D'autres techniques de microscopie électronique ou de diffraction sont également envisageables.

Ces techniques permettent notamment d'observer la présence de défauts structuraux tels que les fautes d'empilement ou des dislocations obliques, et de déterminer l'état de contrainte du dispositif.

La présence de fautes d'empilement ou de dislocations obliques de part et d'autre du canal de conduction d'un dispositif micro-électronique, et le fait que ce canal de conduction repose sur une couche à base de silicium-germanium relaxée, peuvent être des indices de mise en oeuvre du procédé selon la présente invention.

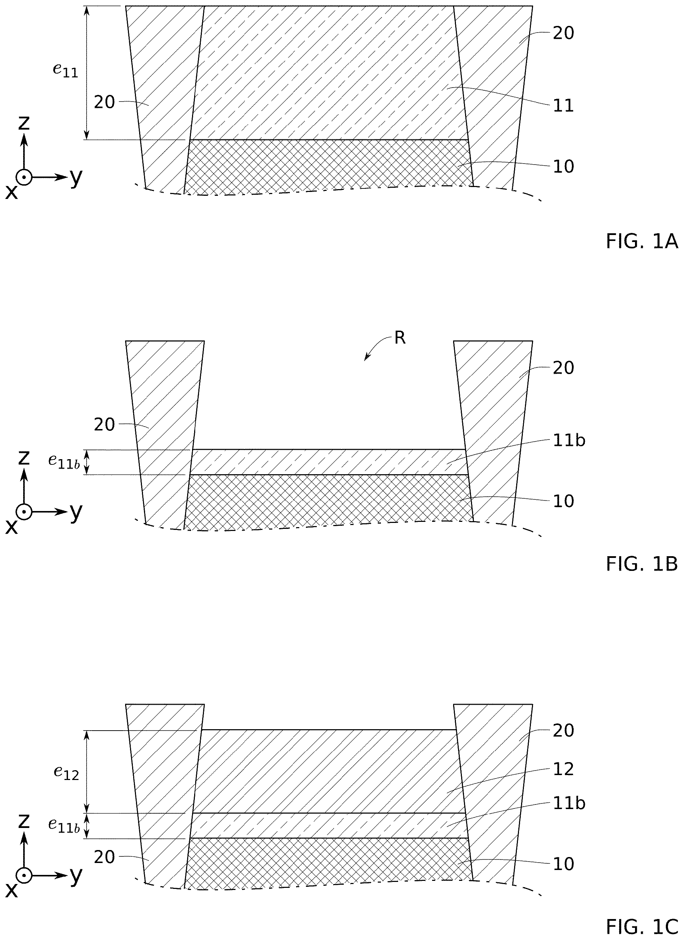

Les figures 1A à 1G illustrent un premier mode de réalisation du procédé de réalisation du dispositif à canal contraint en tension.

Comme illustré à la figure 1A, un substrat à base de silicium est d'abord fourni. Ce substrat peut typiquement être du type silicium sur isolant SOI et comprendre une couche 10 d'oxyde enterrée dénommée BOX (acronyme de « Burried Oxide »), surmontée par une couche 11 de silicium superficielle dénommée « topSi ». Le topSi 11 présente typiquement une épaisseur e11 selon z comprise entre 50 nm et 300 nm. Alternativement, le substrat peut être du type silicium massif également dénommé « bulk ».

Selon une possibilité avantageuse, le procédé est effectué après la formation de tranchées d'isolation 20, typiquement de tranchées d'isolation superficielles STI (acronyme de « Shallow Trench Insulator »). Cela permet d'éviter d'appliquer un budget thermique supplémentaire au dispositif lors de ou après la mise en oeuvre du procédé. Les tranchées d'isolation 20 peuvent être à base d'un matériau ayant tendance à se contracter. Cela favorise l'obtention d'un état de contrainte en tension pour les couches situées entre les tranchées d'isolation 20. Certains oxydes de silicium, par exemple formés par dépôt chimique en phase vapeur à pression sub-atmosphérique SACVD (acronyme de « subatmospheric chemical vapor déposition »), sont connus pour présenter un tel état de contrainte intrinsèque.

Les tranchées d'isolation 20 sont néanmoins uniquement optionnelles. Le procédé peut être mis en oeuvre sur un substrat dépourvu de tranchées d'isolation.

Comme illustré à la figure 1B, selon ce premier mode de réalisation, une cavité R est formée entre les tranchées d'isolation 20, par gravure de la couche de topSi 11. Cette gravure du topSi 11 peut se faire de façon classique, par voie sèche ou par voie humide. La couche de topSi 11 est gravée partiellement, sur une partie seulement de l'épaisseur e11 initiale, de façon à conserver un germe 11b d'épaisseur e11b supérieure ou égale à 5 nm.

Comme illustré à la figure 1C, une couche 12 à base de silicium-germanium est ensuite formée par épitaxie sur le germe 11b. Cette couche 12 présente une épaisseur e12 comprise de préférence entre 15 et 50 nanomètres. La composition chimique de la couche 12 présente de préférence une teneur en germanium comprise entre 20 % et 50 %at. Cette couche 12 est naturellement contrainte en compression lors de la croissance sur le germe 11b en silicium. La couche 12 est également dénommée par la suite couche précontrainte. Elle peut présenter un état de contrainte biaxial en compression dans le plan xy, avec des composantes selon x et/ou selon y typiquement comprises entre -0.5 GPa et -2 GPa.

L'hétéro-épitaxie de la couche précontrainte 12 est de préférence configurée de façon à conserver un léger retrait vis-à-vis du sommet 200 des STI 20. L'épaisseur e12 de la couche précontrainte est donc de préférence inférieure à la profondeur de la cavité R. Cela permet de conserver un espace d'intégration pour la couche active formée par la suite.

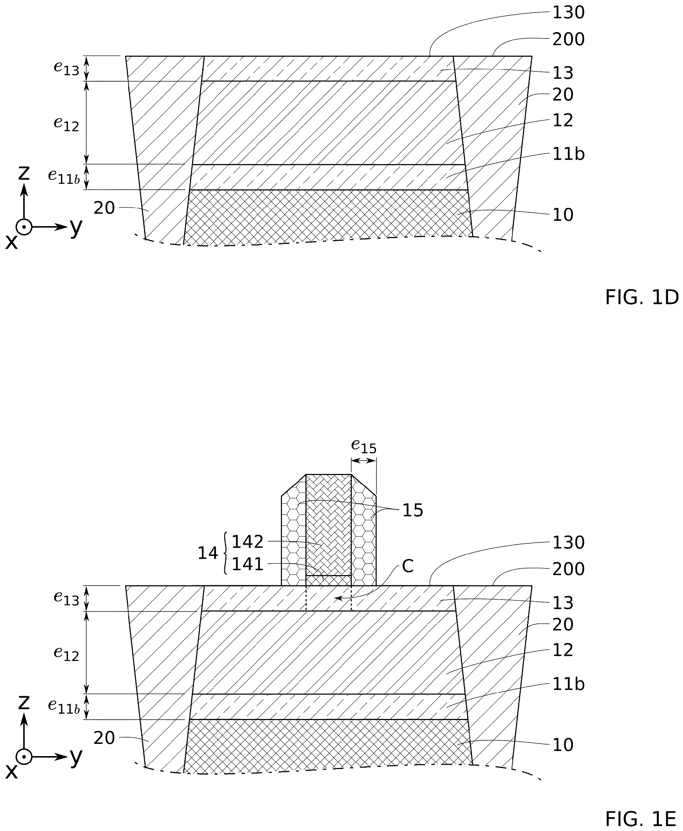

Comme illustré à la figure 1D, la couche active 13 est ensuite formée par épitaxie sur la couche précontrainte 12. La couche active 13 présente typiquement une épaisseur e13 comprise entre 5 nm et 15 nm. Selon une possibilité, l'épitaxie est configurée de sorte à ce que la surface 130 de la couche active 13 affleure les sommets 200 des tranchées d'isolation 20. L'intégration du dispositif est ainsi améliorée. La position relative de la surface 130 vis-à-vis des sommets 200 peut varier, par exemple selon la précision atteignable par l'équipement d'épitaxie.

La couche active 13 formée sur la couche précontrainte 12, est typiquement relaxée mécaniquement. À ce stade, un empilement comprenant les couches 11b, 12, 13 présentant les états de contraintes respectifs suivant : non contraint, en compression, non contraint, est obtenu.

Comme illustré à la figure 1E, un motif de grille 14 comprenant classiquement un oxyde de grille 141 et une grille 142, et des espaceurs 15 flanquant le motif de grille 14, sont formés de façon connue à la surface 130 de la couche active 13.

Le motif de grille 14 définit typiquement le canal de conduction C dans la couche active 13 sous-jacente. Le canal de conduction C se trouve ainsi à l'aplomb du motif de grille 14. Les espaceurs 15 permettent typiquement de définir les régions source et drain, de part et d'autre des espaceurs 15 et du canal de conduction C.

Les espaceurs 15 présentent une largeur e15 selon y de préférence supérieure ou égale à l'épaisseur e13 de la couche active 13. Cela permet d'éviter que des défauts structuraux se développant en oblique depuis les régions situées de part et d'autre des espaceurs 15, jusque sous l'espaceur 15 dans la couche active 13, n'atteignent le canal de conduction C. Les zones de la couche active 13 situées à l'aplomb des espaceurs 15 forment donc des zones tampons de part et d'autre du canal de conduction C.

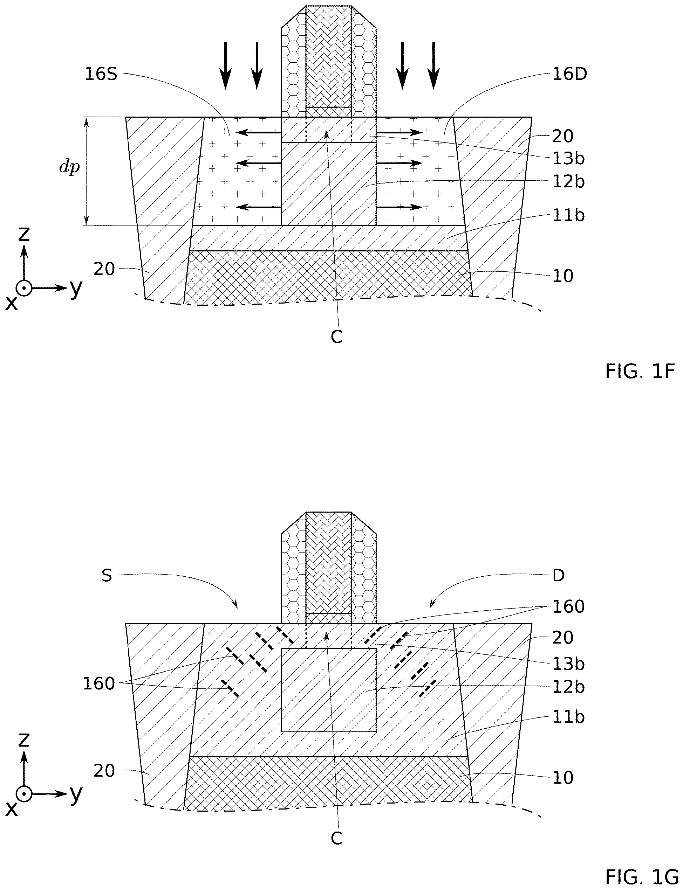

Comme illustré à la figure 1F, après formation du motif de grille 14 et des espaceurs 15, une modification des régions source et drain est effectuée. Dans ce mode de réalisation, les régions source et drain sont au moins en partie modifiées par amorphisation sur une profondeur dp s'étendant jusque dans la couche précontrainte 12. Cette amorphisation se fait typiquement par implantation selon z d'ions ou d'espèces suffisamment massives, par exemple de masse atomique de l'ordre de 70 ou plus. Selon un exemple, cette amorphisation se fait par implantation de germanium. Le germanium, non dopant, permet de choisir le type de dopants ultérieurement lors du dopage des régions source et drain. Selon un exemple alternatif, cette amorphisation se fait par implantation d'arsenic. L'arsenic permet à la fois de doper et d'amorphiser les régions source et drain. Cela permet de gagner une étape de procédé lors de la réalisation du dispositif.

Comme illustré à la figure 1F, les régions amorphisées 16S, 16D ont pour effet de relâcher la contrainte de la couche précontrainte 12,12b. La partie 12b de la couche précontrainte 12 située sous le canal de conduction C se relâche ainsi de façon élastique dans le plan xy, notamment selon y. Cette relaxation de la partie 12b entraîne une mise en tension du canal de conduction C et des zones tampons 13b. La relation d'épitaxie entre la partie 12b et les parties 13b, C de la couche active 13 permet d'exercer efficacement la contrainte en tension dans le canal de conduction C. Le canal de conduction C peut typiquement présenter un état de contrainte biaxial en tension dans le plan xy, avec des composantes selon x et/ou selon y typiquement comprises entre 0.5 GPa et 1,5 GPa. Pour augmenter la relaxation de la couche précontrainte 12, l'amorphisation se fait de préférence selon toute l'épaisseur e12 de la couche précontrainte 12. Cela permet *in fine* d'augmenter la contrainte en tension dans le canal de conduction C. Pour augmenter encore la contrainte en tension dans le canal de conduction C, l'épaisseur e12 est de préférence au moins trois fois supérieure à l'épaisseur e13.

Comme illustré à la figure 1G, après amorphisation, une recroissance par épitaxie en phase solide des régions source et drain S, D est effectuée. Cette recroissance peut être effectuée à une température supérieure ou égale à 600°C, selon un procédé connu de type SPER (acronyme de « Solid-phase Epitaxial Regrowth »). La recristallisation des régions source et drain S, D peut être également effectuée plus rapidement et à plus haute température, par un recuit de type activation ou RTA (acronyme de « Rapid Thermal Annealing »). Cela permet par exemple, en cas d'implantation d'arsenic, d'activer les dopants en même temps que la recristallisation des régions source et drain. Cela permet de gagner une étape de procédé lors de la réalisation du dispositif.

Lors de la recristallisation des régions source et drain S, D, des défauts structuraux 160 apparaissent typiquement. Ces défauts 160 sont essentiellement du type fautes d'empilement ou dislocations inclinées à environ 55° vis-à-vis du plan xy. Les zones tampons 13b permettent avantageusement de contenir ce type de défauts 160 en dehors du canal de conduction C. Le dispositif ainsi réalisé présente un canal de conduction C en tension et sans défauts structuraux.

D'autres modes de réalisation du procédé sont décrits et illustrés dans la suite. Seules les caractéristiques différant du premier mode de réalisation sont détaillées pour ces modes de réalisation, les autres caractéristiques non décrites étant réputées identiques à celles du premier mode de réalisation.

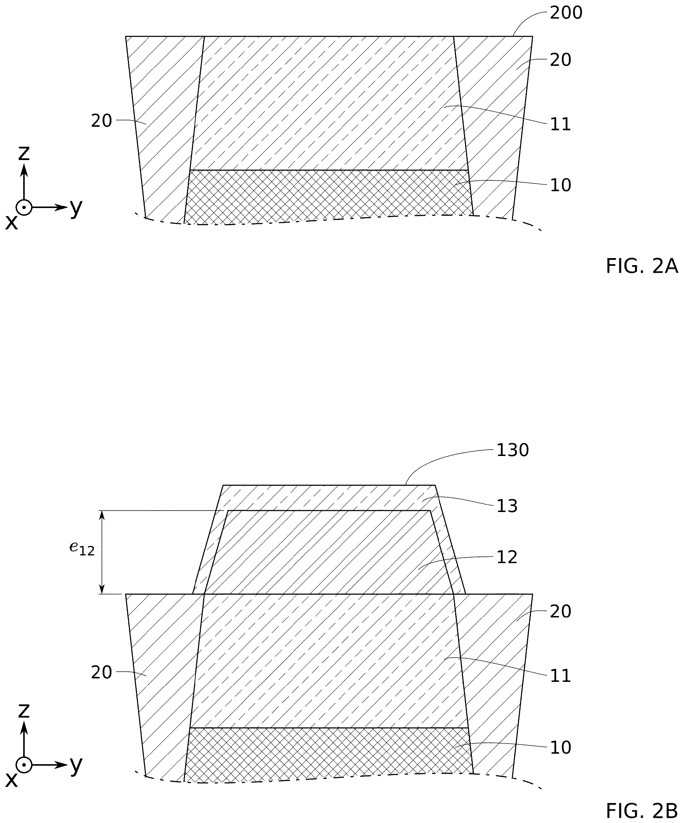

Comme illustré à la figure 2A, le substrat, par exemple de type SOI, est d'abord fourni.

Comme illustré à la figure 2B, dans ce deuxième mode de réalisation, la couche précontrainte 12 à base de SiGe est directement formée sur la couche de topSi 11, sans retrait ou formation de cavités préalables dans le topSi 11. La couche active 13 est ensuite formée par épitaxie sur la couche précontrainte 12. Dans le cas où le substrat comprend des tranchées d'isolation 20 comme illustré sur la figure 2B, les couches 12, 13 croissent typiquement avec des facettes au niveau des tranchées d'isolation 20. Au centre de l'empilement des couches 11, 12, 13, les états de contraintes respectifs suivant : non contraint/en compression/non contraint, sont toujours obtenus.

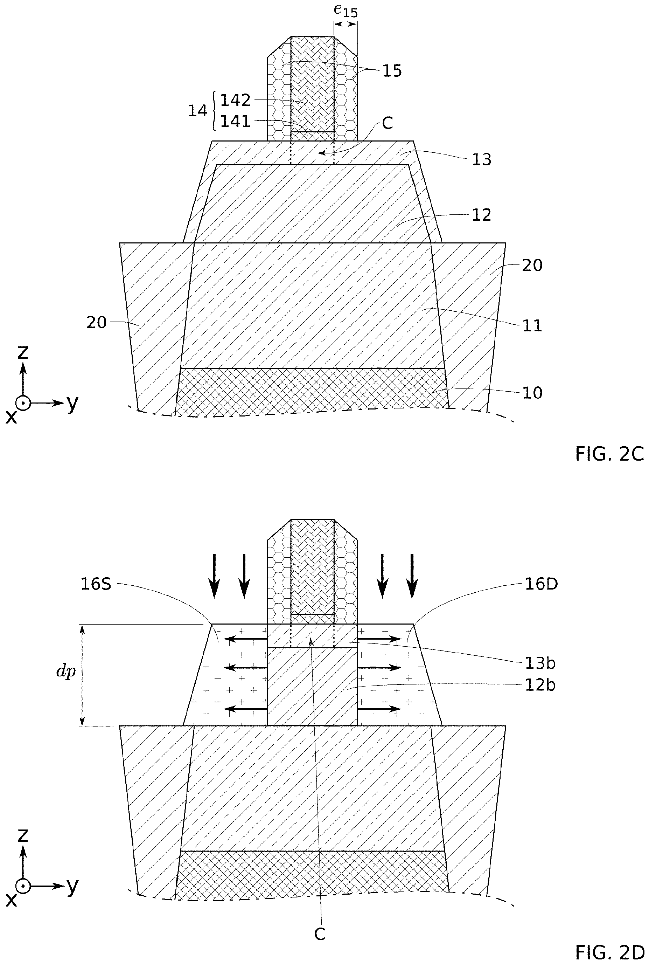

Comme illustré à la figure 2C, le motif de grille 14 et les espaceurs 15 sont formés sur la partie centrale de l'empilement des couches 12, 13.

Comme illustré à la figure 2D, une amorphisation par implantation est effectuée comme précédemment au niveau des régions source et drain. La profondeur dp d'amorphisation s'étend de préférence selon toute l'épaisseur e12 de la couche précontrainte 12. À ce stade, la partie 12b est relâchée élastiquement, et les zones tampons 13b et le canal de conduction C sont mis en tension. La présence de facettes au niveau des zones amorphisées 16S, 16D, correspondant à des surfaces libres, peut permettre d'améliorer la relaxation élastique de la partie 12b de la couche précontrainte 12, et la mise en tension subséquente du canal de conduction C.

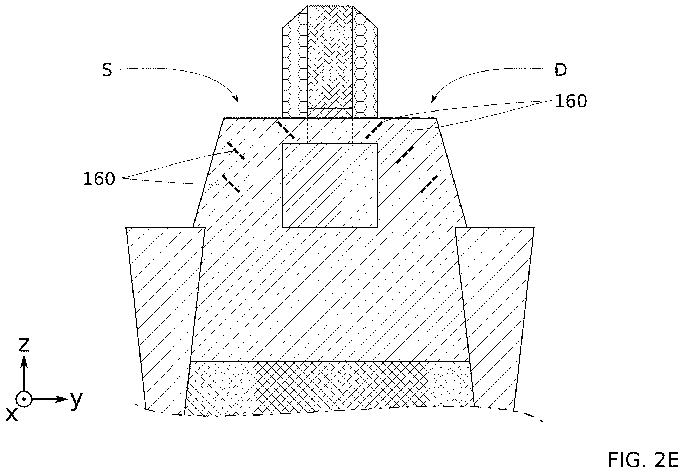

Comme illustré à la figure 2E, une recristallisation ou recroissance par épitaxie en phase solide des régions source et drain S, D est effectuée, comme précédemment. Du fait de la présence de surfaces libres liées aux facettes, la densité de défauts structuraux 160 peut être plus faible dans ce deuxième mode de réalisation.

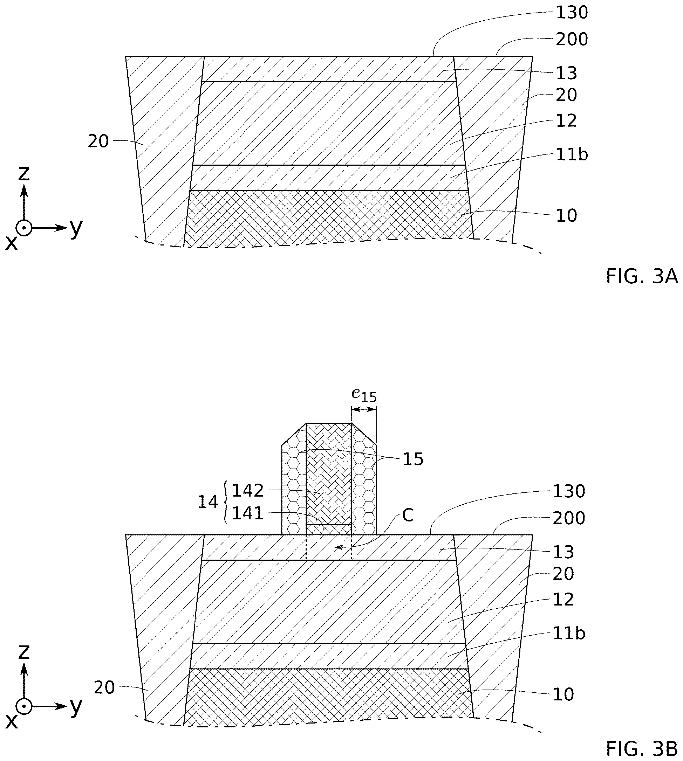

Les figures 3A à 3D illustre un troisième mode de réalisation du procédé dans lequel la modification des régions source et drain est effectué différemment des premier et deuxième modes de réalisation décrits ci-dessus.

Comme illustré à la figure 3A, un substrat comprenant des couches 11b, 12, 13 en empilement est formé, typiquement de la même façon que pour le premier mode de réalisation (figure 1D).

Comme illustré à la figure 3B, le motif de grille 14 et les espaceurs 15 sont formés sur l'empilement des couches 12, 13, comme précédemment. Selon un mode de réalisation le motif de grille 14 est destiné à former une grille pour le transistor. Le motif de grille est alors fonctionnel. Il s'agit alors d'un procédé que l'on peut qualifier de « gate first », c'est-à-dire dans lequel la grille est réalisée au préalable.

Selon un autre mode de réalisation, le motif de grille 14 est destiné à être retiré, après avoir formé les espaceurs 15, pour ensuite être remplacé par un motif fonctionnel de grille. Le motif de grille est alors sacrificiel. Il s'agit alors d'un procédé que l'on peut qualifier de « gate last», c'est-à-dire dans lequel la grille est réalisée dans un second temps.

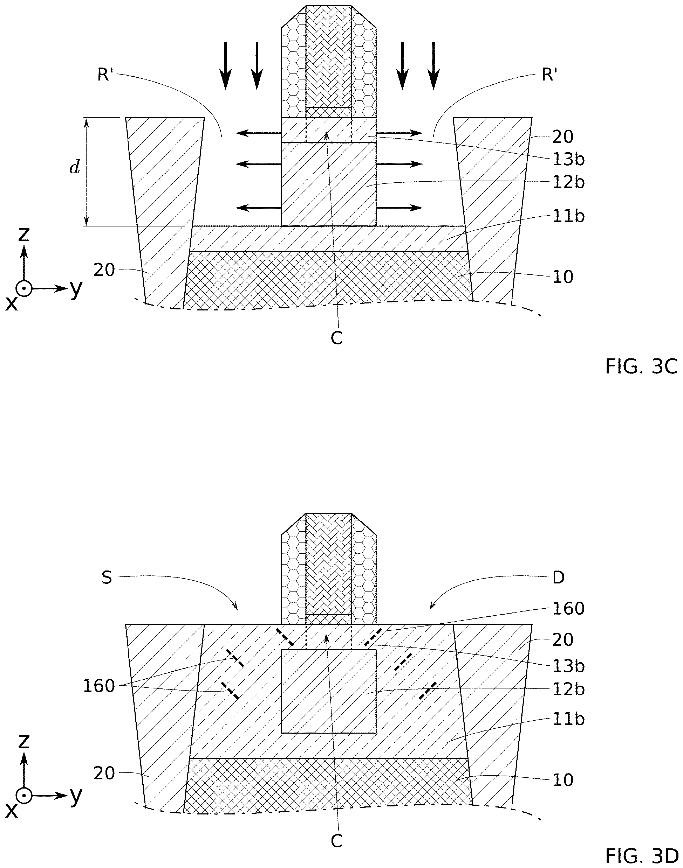

Comme illustré à la figure 3C, dans ce troisième mode de réalisation, la modification des régions source et drain est effectuée par gravure sur une profondeur d s'étendant jusque dans la couche précontrainte 12. La gravure des régions source et drain est de préférence anisotrope, dirigée selon z. Des cavités R' sont ainsi formées au niveau des régions source et drain de part et d'autre des espaceurs 15. Les parties 12b, 13b des couches précontrainte et active 12, 13 correspondantes présentent ainsi des surfaces libres sensiblement normales au plan xy après gravure. Ces surfaces libres permettent à la partie 12b de la couche précontrainte 12 de se relaxer. Cela entraîne comme précédemment une mise en tension du canal de conduction C et des zones tampons 13b.

Comme illustré à la figure 3D, une épitaxie des régions source et drain S, D est ensuite effectuée dans les cavités R'. Selon une possibilité avantageuse, l'épitaxie est réalisée avec du silicium dopé phosphore Si:P. Cela permet d'obtenir directement des régions source et drain dopées, sans avoir recours à une implantation ultérieure. Cela permet également d'appliquer une tension mécanique supplémentaire aux parties 12b, 13b. Le Si:P a en effet tendance à se contracter lors de l'épitaxie. Cela augmente la mise en tension du canal de conduction C.

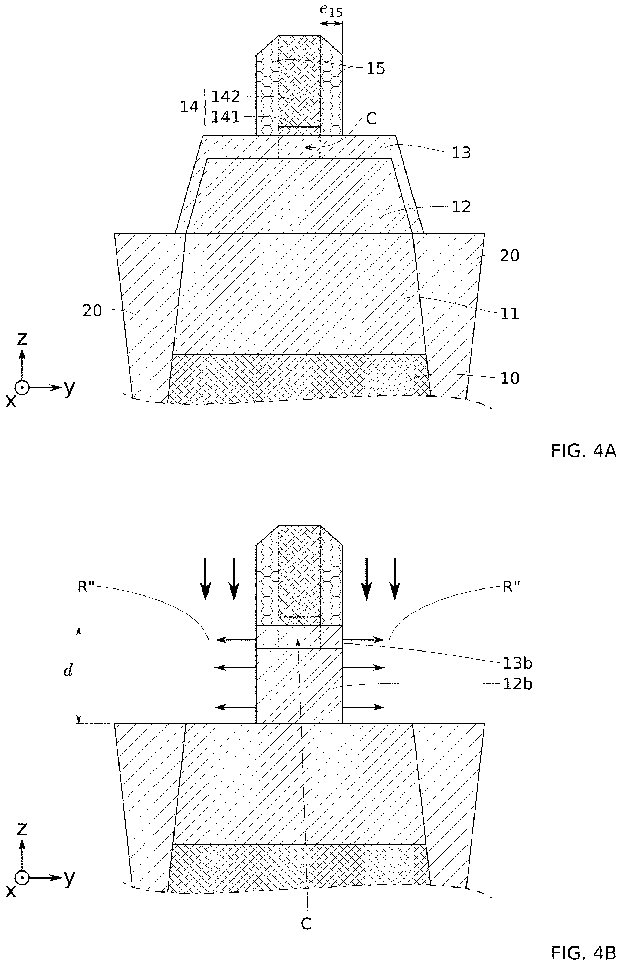

Les figures 4A à 4C illustre un quatrième mode de réalisation du procédé. Dans ce mode de réalisation, l'empilement des couches 12,13 surmonté par le motif de grille 14 et les espaceurs 15 est en saillie du substrat, de façon similaire au cas illustré à la figure 2C.

Comme illustré à la figure 4B, dans ce mode de réalisation, la modification des régions source et drain est effectuée par gravure sur une profondeur d s'étendant jusque dans la couche précontrainte 12, et de préférence selon toute l'épaisseur de la couche précontrainte 12. Comme pour le troisième mode de réalisation, des cavités R" sont ainsi formées au niveau des régions source et drain de part et d'autre des espaceurs 15. Les surfaces libres de la partie 12b permettent la relaxation de la couche précontrainte 12. Cela entraîne comme précédemment une mise en tension du canal de conduction C et des zones tampons 13b.

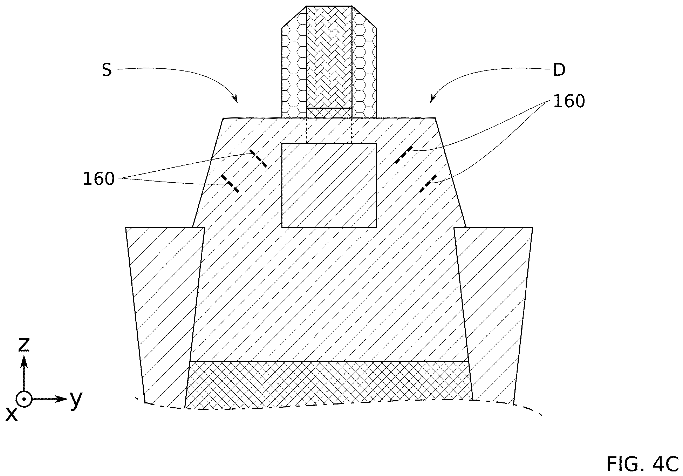

Comme illustré à la figure 4C, une épitaxie des régions source et drain S, D est ensuite effectuée au niveau des cavités R". Comme précédemment, selon une possibilité avantageuse, l'épitaxie est réalisée avec du silicium dopé phosphore Si:P. La croissance des régions source et drain S, D engendre typiquement des facettes. Du fait de la présence de surfaces libres liées aux facettes, la densité de défauts structuraux 160 peut être plus faible dans ce quatrième mode de réalisation.

Au travers des différents modes de réalisation décrit ci-dessus, il apparaît clairement que le procédé selon l'invention permet de réaliser un dispositif à canal contraint en tension, sans dislocations ou défauts structuraux dans ledit canal. La mise en oeuvre du procédé peut se faire de façon localisée, typiquement au niveau de zones dédiées aux NMOS. Avantageusement, les défauts structuraux tels que les fautes d'empilement restent confinés au niveau des régions source et drain et ne sont donc pas électriquement actifs.

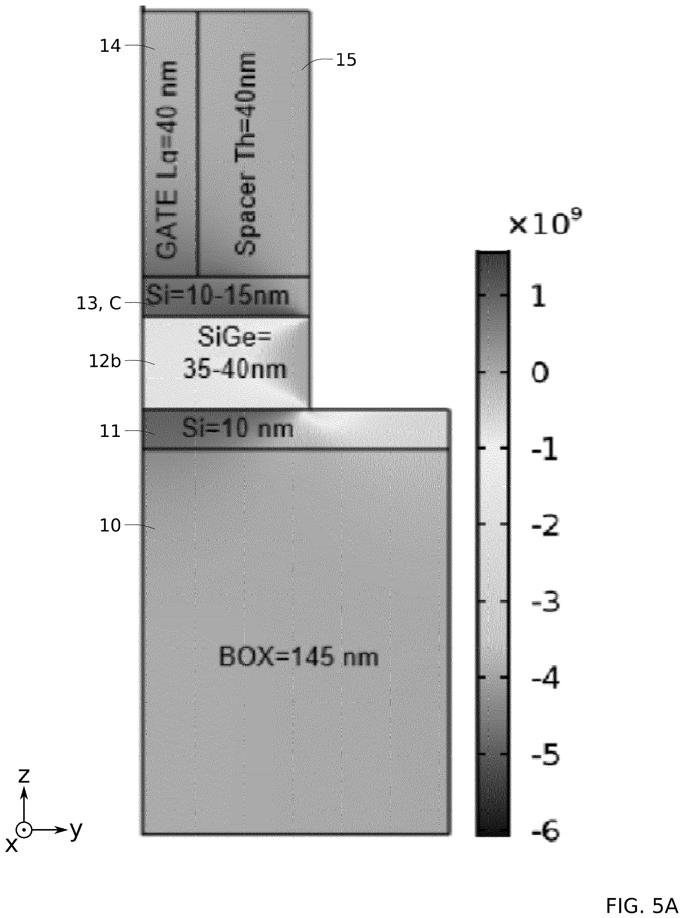

La figure 5A illustre une cartographie de la composante de contrainte selon y, issu de simulation par éléments finis. Dans cette simulation, la partie 12b de la couche précontrainte 12 présente une surface libre et est partiellement relâchée. La portion de couche active 13 au-dessus de cette partie 12b est en tension, en particulier au niveau du canal de conduction C, dans lequel la contrainte en tension atteint une valeur de l'ordre de 1,2 GPa.

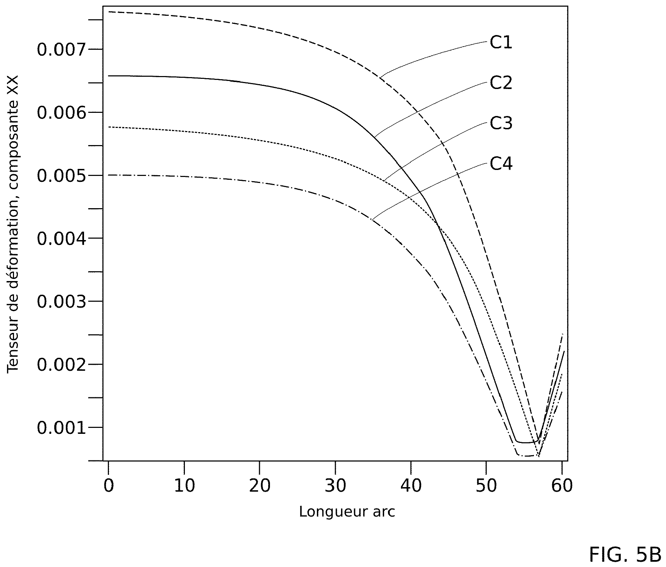

La figure 5B illustre différentes courbes issues des simulations par éléments finis. Ces courbes sont extraites de la portion de couche active 13 telle que représentée à la figure 5A, et trace l'évolution de la composante de contrainte selon y depuis le canal de conduction C jusqu'à la zone tampon située sous l'espaceur 15. La courbe C1 correspond à une simulation avec un canal de conduction d'épaisseur 10 nm et une couche précontrainte SiGe à 40 % en germanium. La courbe C2 correspond à une simulation avec un canal de conduction d'épaisseur 10 nm et une couche précontrainte SiGe à 30 % en germanium. La courbe C3 correspond à une simulation avec un canal de conduction d'épaisseur 15 nm et une couche précontrainte SiGe à 40 % en germanium. La courbe C4 correspond à une simulation avec un canal de conduction d'épaisseur 15 nm et une couche précontrainte SiGe à 30 % en germanium. La valeur la plus élevée de contrainte dans le canal de conduction C (environ 1,2 GPa) est obtenue dans le cas de plus faible épaisseur du canal et de plus grande concentration en germanium dans la couche précontrainte.

L'invention n'est pas limitée aux modes de réalisation précédemment décrits. En particulier une pluralité de dispositifs adjacents peut être réalisée entre deux tranchées d'isolation. Une application particulière concerne les dispositifs RF. D'autres applications, par exemple des dispositifs DC (courant continu), peuvent bénéficier du gain en mobilité permis par l'invention.

## Revendications

1. Procédé de réalisation d'un dispositif microélectronique comprenant au moins les étapes suivantes :
- Une fourniture d'un substrat,
- Une formation, sur le substrat, d'une couche précontrainte (12) présentant une contrainte en compression,
- Une formation d'une couche active (13) sur la couche précontrainte (12), ladite couche active (13) étant destinée à accueillir un canal de conduction (C),
- Une formation d'un motif de grille (14) sur le substrat, ledit motif de grille (14) étant destiné à surmonter le canal de conduction (C),
- Une formation d'espaceurs (15) autour du motif de grille (14),
- Une formation de régions source et drain (S, D) de part et d'autre des espaceurs (15),
- Une modification des régions source et drain (S, D) destinée à générer un état de contrainte en tension dans le canal de conduction (C) sous le motif de grille (14), la modification des régions source et drain (S, D) étant configurée pour relâcher élastiquement la contrainte en compression d'une partie (12b) de la couche précontrainte (12) située sous le canal de conduction (C), de sorte à appliquer l'état de contrainte en tension dans le canal de conduction (C),
ledit procédé étant **caractérisé en ce que** la couche active (13) n'est pas modifiée avant formation des espaceurs (15), de sorte que la couche active (13) présente des zones dites tampon, non modifiées, situées à l'aplomb des espaceurs (15), de part et d'autre du canal de conduction (C).

2. Procédé selon la revendication précédente comprenant en outre
- une formation de tranchées d'isolation (20) dans le substrat,
- une gravure partielle du substrat entre les tranchées d'isolation (20) de sorte à former une cavité (R),
et dans lequel la couche précontrainte (12) et la couche active (13) sont formées par épitaxie dans ladite cavité (R).

3. Procédé selon l'une quelconque des revendications précédentes dans lequel la modification des régions source et drain (S, D) comprend les sous-étapes suivantes :
- Une amorphisation par implantation d'au moins un type d'atome, dans une partie (16S, 16D) de chacune des régions source et drain s'étendant jusque dans la couche précontrainte (12),
- Une recristallisation des parties amorphisées (16S, 16D).

4. Procédé selon la revendication précédente dans lequel l'amorphisation par implantation est effectuée à base d'atomes de germanium ou d'arsenic.

5. Procédé selon l'une quelconque des deux revendications précédentes dans lequel la recristallisation est effectuée par recuit à une température supérieure ou égale à 600°C.

6. Procédé selon l'une quelconque des revendications précédentes dans lequel le motif de grille n'est pas amorphisé, avant ou après modification des régions source et drain (S, D).

7. Procédé selon l'une quelconque des revendications 1 ou 2 dans lequel la modification des régions source et drain (S, D) comprend les sous-étapes suivantes :
- Une gravure d'une partie de chacune des régions source et drain s'étendant jusque dans la couche précontrainte (12),
- Une épitaxie d'un matériau semiconducteur au niveau des parties gravées (R', R").

8. Procédé selon la revendication précédente dans lequel le matériau semiconducteur choisi pour l'épitaxie est du silicium dopé phosphore.

9. Procédé selon l'une quelconque des revendications précédentes dans lequel la modification des régions source et drain s'étend sur toute une épaisseur de la couche précontrainte.

10. Procédé selon l'une quelconque des revendications précédentes dans lequel la formation d'espaceurs (15) est configurée de sorte à ce que les espaceurs (15) présentent une largeur e15 supérieure ou égale à une épaisseur e13 de la couche active (13).

11. Procédé selon l'une quelconque des revendications précédentes dans lequel aucune implantation n'est effectuée avant la formation des espaceurs (15).

12. Procédé selon l'une quelconque des revendications précédentes dans lequel la formation de la couche précontrainte (12) est configurée de sorte à ce que ladite couche précontrainte (12) présente une épaisseur e12 comprise entre 15 nm et 50 nm, et dans lequel la formation de la couche active (13) est configurée de sorte à ce que ladite couche active (13) présente une épaisseur e13 comprise entre 5 nm et 15 nm.

13. Procédé selon la revendication précédente dans lequel les épaisseurs e12, e13 sont choisies de sorte que e12 ≥ 3.e13.

14. Dispositif microélectronique comprenant un substrat, un motif de grille (14) surmontant ledit substrat, des espaceurs (15) bordant ledit motif de grille (14), et des régions dites source et drain (S, D) de part et d'autre du motif de grille (14), ledit dispositif comprenant en outre un canal de conduction (C) sous le motif de grille (14) et présentant un état de contrainte en tension, le dispositif comprenant en outre une couche (12) partiellement relaxée sur le substrat, et une couche active (13) accueillant le canal de conduction (C), sur ladite couche (12) partiellement relaxée, ladite couche active (13) présentant l'état de contrainte en tension au niveau du canal de conduction (C) le dispositif étant **caractérisé en ce que** la couche active (13) présente des dislocations (160) de part et d'autre du canal de conduction (C), au niveau des régions source et drain (S, D), sans dislocations dans ledit canal de conduction (C).

15. Dispositif microélectronique selon la revendication précédente dans lequel la couche active (13) est à base de silicium et la couche (12) partiellement relaxée est à base de silicium-germanium présentant une concentration en germanium comprise entre 20% et 50%.

16. Dispositif microélectronique selon l'une quelconque des deux revendications précédentes dans lequel les espaceurs (15) présentent une largeur e15 supérieure ou égale à une épaisseur e13 de la couche active (13), de préférence supérieure ou égale à 30 nm.
